# EUROPEAN PATENT APPLICATION

(11) **EP 2 755 288 A2**
(43) Date of publication of application: **16.07.2014**
(21) Application number: 13197575.7
(22) Date of filing: 16.12.2013
(51) Int. Cl.: H01S 3/10, H01S 3/106, H01S 5/14, H01S 5/022

(54) **Stablized pump laser with output reflector on polarizing optical fiber**

(30) Priority: 13.01.2013 US 201313740231
(71) Applicant: Honeywell International Inc., Morristown, NJ 07962-2245 (US)
(72) Inventor: Qiu, Tiequn, Morristown, NJ New Jersey 07962-2245 (US); Sanders, Steven J., Morristown, NJ New Jersey 07962-2245 (US)
(74) Representative: Houghton, Mark Phillip

(57) **Abstract**

A laser apparatus comprises a pump laser device, and a polarizing optical fiber having a proximal end and a distal end, with the polarizing optical fiber coupled to the pump laser device at the proximal end. At least one output reflector (122) is written on the polarizing optical fiber (120) toward the distal end. Only one polarization mode is supported when a laser beam is transmitted through the polarizing optical fiber (120) from the pump laser device. The laser apparatus may comprise a packaged laser diode (110) having an external cavity, the external cavity comprising an intra-cavity lens (114) and an optical fiber (120) having a grating as output reflector (122). An intra-cavity coiled section (124) of the optical fiber (120) selects one polarisation mode in dependence of the coiling radius.

## Description

### BACKGROUND

In precision rotation rate sensing applications by fiber optic gyroscopes, the bias performance is often sensitive to the light source stability used in the gyroscope. The light source stability in turn is sensitive to the diode pump laser stability. To improve the pump laser stability, a fiber Bragg grating fabricated on a long polarization maintaining (PM) fiber is typically used as an output reflector to lock the laser emission wavelength. In addition, broad fiber Bragg grating reflection bandwidths and long polarization maintaining fiber lengths have been adopted to keep the laser operating at a "coherence collapsed" mode so that stable output power can be realized.

The PM fiber containing the Bragg grating supports two polarization modes with birefringence, one along the fast axis, and the other along the slow axis of the PM fiber. The laser effectively has two cavities of different round-trip lengths corresponding to the two polarization axes. Although the gain medium (semiconductor waveguide) in the laser often provides gain for only one polarization axis, the polarization cross-coupling at the interface between the polarization maintaining fiber and the gain medium effectively provides gain for both polarization states. Interference of the two polarization modes produces a temperature sensitive reflection coefficient of the output mirror, leading to fluctuations of output power from the pump laser. These fluctuations create instabilities in rotation rate measurements of the gyroscope.

In another conventional approach, a 90° splice of the polarization maintaining fiber has been employed to reduce the effective birefringence of the fiber. Nevertheless, this approach still supports two polarization modes in the pump laser cavity, which creates instabilities in rotation rate measurements of the gyroscope.

### SUMMARY

A laser apparatus comprises a pump laser device, and a polarizing optical fiber having a proximal end and a distal end, with the polarizing optical fiber coupled to the pump laser device at the proximal end. At least one output reflector is written on the polarizing optical fiber toward the distal end. Only one polarization mode is supported when a laser beam is transmitted through the polarizing optical fiber from the pump laser device.

### BRIEF DESCRIPTION OF THE DRAWINGS

Understanding that the drawings depict only exemplary embodiments and are not therefore to be considered limiting in scope, the exemplary embodiments will be described with additional specificity and detail through the use of the accompanying drawings, in which:
Figure 1 illustrates a stabilized pump laser apparatus according to one embodiment; and
Figure 2 is an exploded perspective view of some of the components of the stabilized pump laser apparatus of Figure 1.

### DETAILED DESCRIPTION

In the following detailed description, embodiments are described in sufficient detail to enable those skilled in the art to practice the invention. It is to be understood that other embodiments may be utilized without departing from the scope of the invention. The following detailed description is, therefore, not to be taken in a limiting sense.

A stabilized semiconductor laser (also called a pump laser) apparatus is provided that includes a semiconductor laser chip (or waveguide) optically coupled to a polarizing optical fiber having at least one output reflector. The semiconductor laser apparatus has reduced temperature sensitivity from removal of power fluctuations. This improves the wavelength and power stability when the pump laser apparatus is used to pump the light source of another device such as a fiber optic gyroscope.

The polarizing optical fiber has substantially high loss for one fiber axis and substantially low loss for the other orthogonal fiber axis. The loss difference is so high that the polarizing optical fiber effectively appears as a fiber that only supports one polarization mode. Using a polarizing optical fiber coupled to the semiconductor laser chip effectively eliminates the unwanted polarization mode anywhere in the laser cavity, and completely removes the interfering effects caused by the two cavity lengths associated with the two polarization axes in a polarization maintaining fiber.

The polarizing optical fiber can have one or more output reflectors such as fiber Bragg gratings fabricated thereon, which provide an output coupler for the pump laser apparatus. The polarizing optical fiber can be specially treated to have the desired photorefractive properties for writing fiber Bragg gratings thereon. The Bragg grating can be written directly on the polarizing optical fiber by standard fabrication techniques. Writing Bragg gratings directly on the polarizing optical fiber has the advantage of avoiding polarization cross couplings induced by splicing non-polarizing polarization maintaining fiber to a polarizer and a reflector, which is done in some prior methods. The current approach significantly reduces the unwanted polarization mode in the laser cavity, which is the major cause of laser power instability.

In one embodiment, a fiber Bragg grating has a reflection bandwidth of about 0.5 nm or greater, and a reflection coefficient of about 2 to about 10 percent. The distance of the fiber Bragg grating from a laser diode chip of the pump laser is at least about 1 meter. In addition, the polarizing optical fiber is kept at a bend radius that optimizes its polarizing property at an operating wavelength, such as 980 nm when the laser is used to pump an Erbium-doped fiber light source.

The present approach improves the stability of the fiber-based light sources used in fiber optic gyroscopes. Such light source stability is one of the important contributors to gyroscope performance.

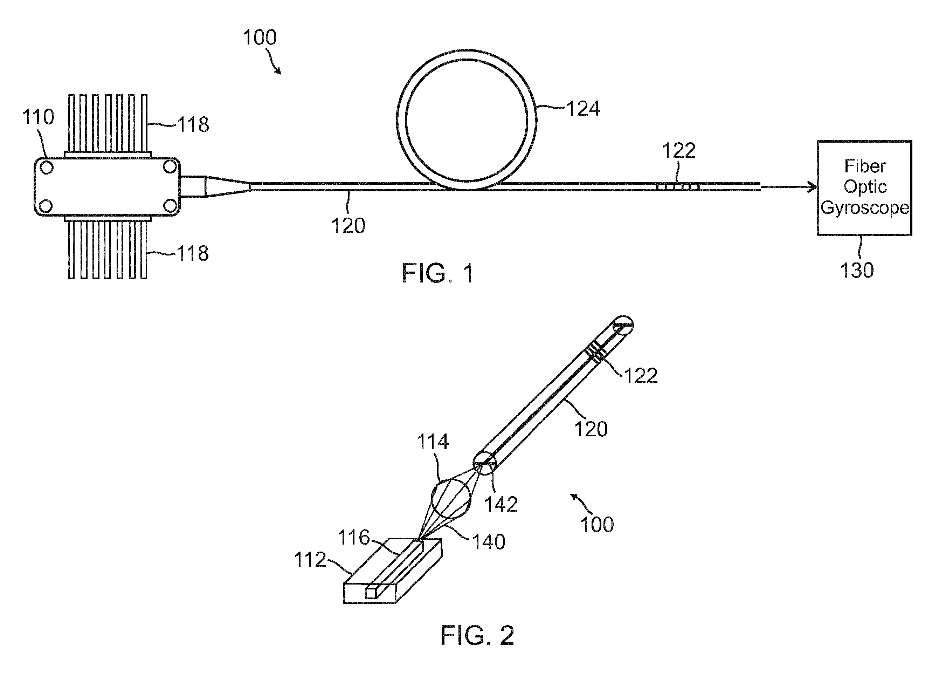

Figures 1 and 2 illustrate a stabilized pump laser apparatus 100 according to one embodiment, in which only one polarization mode is supported in the laser cavity. The pump laser apparatus 100 includes a semiconductor laser diode package 110 that is coupled to a polarizing optical fiber 120. The laser diode package 110 houses a laser diode chip 112 and other optical components such as a lens 114, a mirror, and the like. The laser diode 112 includes a gain medium 116 such as a semiconductor waveguide. The laser diode 112 is in optical communication with polarizing optical fiber 120 through lens 114, as shown in Figure 2. The laser diode package 110 also has a plurality of electrical connectors 118 for coupling laser diode chip 112 to outside electrical sources.

The polarizing optical fiber 120 includes at least one output reflector 122, such as a fiber Bragg grating, which is located toward a distal end of polarizing optical fiber 120. The polarizing optical fiber 120 includes a pigtail coil section 124 between the laser diode package 110 and output reflector 122, as shown in Figure 1. The pigtail coil section 124 provides strong attenuation to one polarization state of the fiber while substantially having no attenuation to the other polarization state through proper selection of the bending radius of the coil. In one embodiment, the length of the polarization fiber is at least 1 meter long to keep the laser operating in the "coherence collapsed" region.

As shown in Figure 2, a laser beam 140 is emitted from laser diode 112 through lens 114 and into polarizing optical fiber 120, which supports a single polarization mode along axes 142.

In one embodiment, pump laser apparatus 100 can be optically coupled to a fiber optic gyroscope 130, as shown in Figure 1. The pump laser apparatus 100 can also be coupled to other devices such as fiber light sources.

In an exemplary embodiment, the pass axes of the polarizing fiber are aligned as close as possible to the axis of the semiconductor chip that has maximum gain. The strong surface reflections of the chip facing the polarizing fiber and the lenses can be minimized through an antireflection coating to avoid parasitic cavities effects in the pump laser apparatus.

### Example Embodiments

Example 1 includes a laser apparatus comprising a pump laser device; a polarizing optical fiber having a proximal end and a distal end, the polarizing optical fiber coupled to the pump laser device at the proximal end; and at least one output reflector written on the polarizing optical fiber toward the distal end. Only one polarization mode is supported when a laser beam is transmitted through the polarizing optical fiber from the pump laser device.

Example 2 includes the laser apparatus of Example 1, wherein the pump laser device comprises a laser diode housed in a package that includes a lens.

Example 3 includes the laser apparatus of Example 2, wherein the laser diode includes a gain medium.

Example 4 includes the laser apparatus of any of Examples 2-3, wherein the laser diode is optical communication with the polarizing optical fiber through the lens.

Example 5 includes the laser apparatus of any of Examples 2-4, wherein the package includes a plurality of electrical connectors for coupling the laser diode to outside electrical sources.

Example 6 includes the laser apparatus of any of Examples 1-5, wherein the output reflector comprises at least one fiber Bragg grating fabricated toward the distal end of the polarizing optical fiber.

Example 7 includes the laser apparatus of any of Examples 1-6, wherein the polarizing optical fiber includes a pigtail coil section between the pump laser device and the output reflector.

Example 8 includes the laser apparatus of any of Examples 1-7, wherein the pump laser device is optically coupled to a fiber optic gyroscope through the polarizing optical fiber.

Example 9 includes an apparatus comprising a laser package; a pump laser diode housed in the package; at least one lens housed in the package and in optical communication with the pump laser diode; a polarizing optical fiber having a proximal end and a distal end, the polarizing optical fiber coupled to the pump laser diode at the proximal end; and one or more fiber Bragg gratings written on the polarizing optical fiber toward the distal end. Only one polarization mode is supported when a laser beam is transmitted through the polarizing optical fiber from the pump laser diode.

Example 10 includes the apparatus of Example 9, further comprising a fiber optic gyroscope optically coupled to the polarizing optical fiber at the distal end.

Example 11 includes a method of stabilizing a pump laser device, the method comprising providing a polarizing optical fiber having a first end and an opposite second end; forming at least one output reflector on the polarizing optical fiber toward the second end; and coupling the first end of the polarizing optical fiber to an output of the pump laser device.

Example 12 includes the method of Example 11, wherein the output reflector comprises a fiber Bragg grating.

Example 13 includes the method of any of Examples 11 and 12, further comprising optically coupling the second end of the polarizing optical fiber to a fiber optic gyroscope.

The present invention may be embodied in other forms without departing from its essential characteristics. The described embodiments are to be considered in all respects only as illustrative and not restrictive. Therefore, it is intended that this invention be limited only by the claims and the equivalents thereof.

## Claims

1. A laser apparatus, comprising:
a pump laser device;
a polarizing optical fiber having a proximal end and a distal end, the polarizing optical fiber coupled to the pump laser device at the proximal end; and
at least one output reflector written on the polarizing optical fiber toward the distal end;
wherein only one polarization mode is supported when a laser beam is transmitted through the polarizing optical fiber from the pump laser device.

2. The laser apparatus of claim 1, wherein the pump laser device comprises a laser diode housed in a package that includes a lens, wherein the laser diode includes a gain medium and is in optical communication with the polarizing optical fiber through the lens.

3. The laser apparatus of claim 2, wherein the package includes a plurality of electrical connectors for coupling the laser diode to outside electrical sources.

4. The laser apparatus of claim 1, wherein the output reflector comprises at least one fiber Bragg grating fabricated toward the distal end of the polarizing optical fiber.

5. The laser apparatus of claim 1, wherein the pump laser device is optically coupled to a fiber optic gyroscope through the polarizing optical fiber.

6. An apparatus, comprising:
a laser package;
a pump laser diode housed in the package;
at least one lens housed in the package and in optical communication with the pump laser diode;
a polarizing optical fiber having a proximal end and a distal end, the polarizing optical fiber coupled to the pump laser diode at the proximal end; and
one or more fiber Bragg gratings written on the polarizing optical fiber toward the distal end;
wherein only one polarization mode is supported when a laser beam is transmitted through the polarizing optical fiber from the pump laser diode.

7. The apparatus of claim 6, further comprising a fiber optic gyroscope optically coupled to the polarizing optical fiber at the distal end.

8. A method of stabilizing a pump laser device, the method comprising:
providing a polarizing optical fiber having a first end and an opposite second end;
forming at least one output reflector on the polarizing optical fiber toward the second end; and
coupling the first end of the polarizing optical fiber to an output of the pump laser device.

9. The method of claim 8, wherein the output reflector comprises a fiber Bragg grating written on the polarizing optical fiber.

10. The method of claim 8, further comprising optically coupling the second end of the polarizing optical fiber to a fiber optic gyroscope.
